# EUROPÄISCHE PATENTSCHRIFT

(11) **EP 0 855 090 B1**
(45) Veröffentlichungstag und Bekanntmachung des Hinweises auf die Patenterteilung: **02.01.2003**
(21) Anmeldenummer: 97922877.2
(22) Anmeldetag: 26.04.1997
(51) Int. Cl.: H01L 25/16, H01L 23/538

(54) **MULTICHIPMODUL**
MULTICHIP MODULE
MODULE MULTIPUCE

(30) Priorität: 09.08.1996 DE 19632200
(43) Veröffentlichungstag der Anmeldung: 29.07.1998
(73) Patentinhaber: ROBERT BOSCH GMBH, 70442 Stuttgart (DE)
(72) Erfinder: NAPIERALA, Dieter, D-31135 Hildesheim (DE)
(86) Internationale Anmeldenummer: DE9700856
(87) Internationale Veröffentlichungsnummer: WO98007193

(56) Entgegenhaltungen:
- EP-A- 0 282 396
- EP-A- 0 675 539
- WO-A-95/08189
- US-A- 5 319 243
- US-A- 5 428 885
- US-A- 5 562 837
- PATENT ABSTRACTS OF JAPAN vol. 096, no. 008, 30.August 1996 & JP 08 088474 A (TAIYO YUDEN CO LTD), 2.April 1996,
- PROCEEDINGS OF THE ELECTRONIC COMPONENTS AND TECHNOLOGY CONFERENCE, ORLANDO, JUNE 1 - 4, 1993, Nr. CONF. 43, 1.Juni 1993, INSTITUTE OF ELECTRICAL AND ELECTRONICS ENGINEERS, Seiten 1-7, XP000380004 RAO TUMMALA ET AL: "OVERVIEW OF IBM GLASS CERAMIC PACKAGING TECHNOLOGY"
- IEICE TRANSACTIONS, Bd. E74, Nr. 8, 1.August 1991, Seiten 2309-2316, XP000268465 UMEZAWA K ET AL: "GAAS MULTICHIP PACKAGE FOR SUPERCOMPUTER"
- IEEE TRANSACTIONS ON COMPONENTS,HYBRIDS,AND MANUFACTURING TECHNOLOGY, Bd. CHMT-7, Nr. 2, Juni 1984, NEW YORK US, Seiten 193-196, XP002036297 R.K. SPPIELBERGER ET AL.: "Silicon-on-Silicon Packaging"
- PROCEEDINGS OF THE MULTI CHIP MODULE CONFERENCE (MCMC), SANTA CRUZ, MAR. 18 - 20, 1992, Nr. CONF. 1, 18.März 1992, INSTITUTE OF ELECTRICAL AND ELECTRONICS ENGINEERS, Seiten 8-11, XP000299670 TOSHIO SUDO: "SILICON-ON-SILICON TECHNOLOGY FOR CMOS-BASED COMPUTER SYSTEMS"
- IBM TECHNICAL DISCLOSURE BULLETIN, Bd. 23, Nr. 3, August 1980, NEW YORK US, Seite 966 XP002036298 P.F. IAFRATE ET AL.: "Integrated Circuit Wafer Package"

## Beschreibung

### Stand der Technik

Die Erfindung geht von einem Multichipmodul nach der im Oberbegriff des Anspruchs 1 angegebenen Gattung aus.

Multichipmodule bestehen aus einem Trägersubstrat auf dem mehrere gehäuselose IC-Bauelemente und weitere elektronische Bauelemente, wie z.B. SMD-Bauelemente, aufgebracht sind. Zum Schutz der empfindlichen Bauelemente vor Umwelteinflüssen wird ein Deckel oder eine Kappe auf das Trägersubstrat aufgebracht. Das Trägersubstrat ist in der Regel als Mehrlagen-Leiterplatte oder Multilayer-Keramik ausgebildet, so daß die IC-Bauelemente und die weiteren elektronischen Bauelemente über mehrere Lagen des Trägersubstrats miteinander verbunden werden können. Die elektrischen Anschlüsse des Multichipmoduls sind über Durchkontaktierungen mit auf der Unterseite des Trägersubstrats vorgesehenen Lötkontakten verbunden, die vorteilhaft in Form von Löthockern, sogenannten Solder bumps, ausgestaltet sind und zur mechanischen und elektrischen Verbindung des Multichipmoduls mit entsprechend ausgerichteten Kontaktflecken eines Baugruppenträgers dienen. Die auf der als Bestückungsseite vorgesehenen Oberseite des Multichipmoduls aufgebrachten IC-Bauelemente weisen eine Vielzahl von Anschlüssen auf, die an Leiterbahnen auf der Oberseite des Multichipmoduls angeschlossen werden. Zu diesem Zweck werden die IC-Bauelemente auf die Oberseite des Moduls aufgeklebt oder in anderer geeigneter Weise aufgebracht und über Bonddrähte mit in den Leiterbahnen integrierten Anschlüssen verbunden. Zur Unterdrückung der Übertragung von elektrischen Störsignalen ist weiterhin bekannt, diskrete Widerstände an die einzelnen mit den Bonddrähten verbundenen Anschlußleiterbahnen eines IC-Bauelementes anzuschließen. Diese Widerstände müssen auf dem Multichipmodul außerhalb der für die Aufbringung des jeweiligen IC-Bauelementes benötigten Fläche aufgebracht werden. Nachteilig bei dem bisherigen Stand der Technik ist, daß die für die Aufbringung des IC-Bauelementes benötigte Fläche des Multichipmoduls größer als die Grundfläche des IC-Bauelementes sein muß, um eine Beschädigung von Schaltungsteilen und einzelnen Bauelementen auf der Oberseite des Moduls während der Aufbringung des IC's zu vermeiden. Da auf dieser Fläche keine Leiterbahnen und Bauelemente, wie z.B. Widerstände, vorgesehen sein dürfen, muß die Oberfläche des Multichipmoduls entsprechend vergrößert werden, um alle erforderlichen Bauelemente und Leiterbahnen auf die Oberseite aufbringen zu können. Bei einem Multichipmodul mit mehreren IC's, von denen jeder einzelne zahlreiche Anschlüsse aufweist, die mit Entstörwiderständen verbunden werden müssen, vergrößert sich der Flächenbedarf auf der Oberseite des Multichipmoduls erheblich. Dies wirkt sich nachteilig auf Herstellungskosten und Größe des Moduls aus. Weiterhin ist nachteilig, daß die zur Unterdrückung von Störsignalen vorgesehenen diskreten Widerstands-Bauelemente und deren elektrische Anbindungen auf der Bestückungsseite des Multichipmoduls relativ viel Platz beanspruchen. Besonders nachteilig ist, daß die Vielzahl der elektrischen Verbindungen eines IC-Bauelementes mit den zur Entstörung vorgesehenen Widerständen eine Erhöhung der Lagenzahl des Trägersubstrats erforderlich macht. Dies wiederum erschwert den Entwurf des Leiterbahnlayouts und wirkt sich nachteilig auf die Herstellungskosten aus.

### Vorteile der Erfindung

Das erfindungsgemäße Multichipmodul mit dem kennzeichnenden Merkmal des Hauptanspruchs hat demgegenüber den Vorteil, daß zwischen jedem IC-Bauelement und dem Trägersubstrat des Moduls ein Trägerteil vorgesehen ist, auf dem Bauelemente und Teile der Leiterbahnverdrahtung aufgebracht werden können. Da das Trägerteil unabhängig vom Fertigungsverfahren des Trägersubstrats hergestellt werden kann, ist es möglich, durch die Wahl geeigneter Herstellungsverfahren feinere Leiterbahnstrukturen und kleiner dimensionierte Bauelemente auf dem Trägerteil vorzusehen. Hierdurch kann sowohl der Platzbedarf auf der Oberseite des Trägersubstrats als auch die Anzahl der erforderlichen Lagen der Trägersubstrats reduziert werden, wodurch die Herstellungskosten des Moduls gesenkt werden können.

Weitere vorteilhafte Ausgestaltungen und Weiterbildungen der Erfindung werden durch die in den Unteransprüchen angegebenen Merkmale ermöglicht. Vorteilhaft ist es, die Grundfläche des Trägerteils größer als die Grundfläche des entsprechenden IC-Bauelementes vorzusehen. Auf dem nicht durch das IC-Bauelement abgedeckten Teil des Trägerteils können dann die ersten und zweiten Anschlußflächen für die auf dem Trägerteil vorgesehenen Bauelemente und Leiterbahnen platzsparend aufgebracht und über Bonddrähte mit dem IC-Bauelement und den Anschlüssen auf der Bestückungsseite des Trägersubstrats verbunden werden. Da das Trägerteil mit dem IC-Bauelement auf der Bestückungsseite des Trägersubstrates so aufgebracht werden kann, daß es bis auf einen kleinen Abstand an die Anschlußleiterbahnen angrenzt, wird auch die beim Stand der Technik nicht genutzte Fläche zwischen den Anschlußleiterbahnen und dem IC-Bauelement genutzt.

Ein erheblicher Vorteil besteht darin, daß die zur Unterdrückung von Störsignalen erforderlichen diskreten Widerstände direkt auf der Oberseite des Trägerteils aufgebracht werden können. Da die elektrische Anbindung der Widerstände auf dem Trägerteil erfolgt, entfällt auf dem Trägersubstrat des Moduls der zusätzliche Platzbedarf für die Widerstände und deren Verdrahtung.

Weiterhin ist vorteilhaft, als Trägerteil ein Siliciumsubstrat vorzusehen, auf dem Leiterbahnen und Widerstände mit großer Präzision gefertigt werden können.

Ganz besonders vorteilhaft ist es, das Trägerteil als Keramiksubstrat und insbesondere als keramisches Mehrlagensubstrat vorzusehen, da hierdurch Leiterbahnverbindungen und einzelne Bauelemente relativ einfach auf den verschiedenen Lagen des Trägerteils angeordnet werden können. Hierdurch kann die Leiterbahndichte und die Anzahl der Verdrahtungslagen auf dem Trägersubstrat erheblich reduziert werden.

Besonders vorteilhaft ist weiterhin, die zur Entstörung vorgesehenen Widerstände in Dünn- oder Dickschichttechnik auf dem keramischen Trägerteil herzustellen. Da derartige Strukturen sehr klein hergestellt werden können, läßt sich hierdurch der Platzbedarf für die Widerstände erheblich reduzieren.

Weiterhin vorteilhaft ist, in dem keramischen Mehrlagensubstrat Bauelemente mit kapazitiven oder induktiven Funktionen vorzusehen, die in bekannter Weise in dem Keramiksubstrat integriert werden können.

Vorteilhaft kann das Trägerteil mit dem IC-Bauelement auf das Trägersubstrat des Moduls einfach aufgeklebt werden. Zur verbesserten Wärmeableitung der durch das IC-Bauelement erzeugten Wärme kann dabei ein Wärmeleitkleber benutzt werden.

### Zeichnung

Ein Ausführungsbeispiel der Erfindung ist in der Zeichnung dargestellt und wird in der nachfolgenden Beschreibung näher erläutert. Die Figur zeigt einen stark vereinfachten, nicht maßstäblichen Querschnitt durch ein ersten Ausführungsbeispiel des erfindungsgemäßen Multichipmoduls mit dem aufgeklebten Trägerteil und einem einzelnen IC-Bauelement.

### Beschreibung des Ausführungsbeispiels

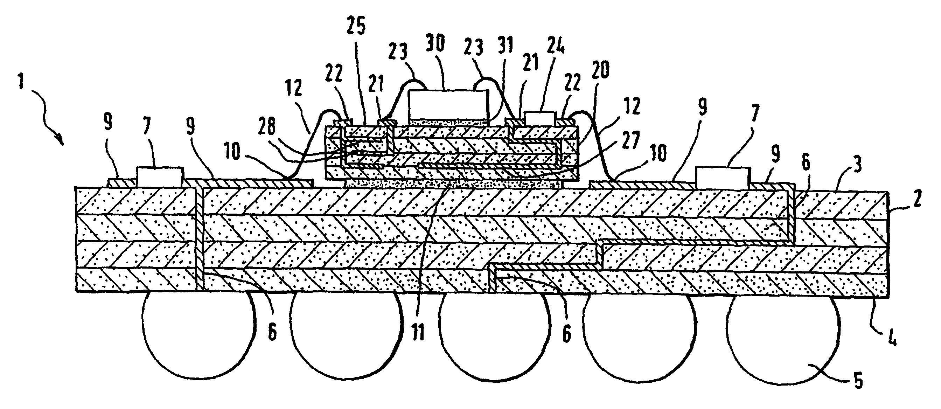

In der Fig. 1 ist ein erstes Ausführungsbeispiel des erfindungsgemäßen Multichipmoduls dargestellt. In dem hier gezeigten Ausführungsbeispiel besteht das Trägersubstrat 2 des Multichipmoduls 1 aus einer Mehrlagenleiterplatte. Auf der als Bestückungsseite vorgesehenen Oberseite 3 des Moduls 1 befinden sich verschiedene Bauelemente 7, die über Leiterbahnen 9 auf der Oberseite und den inneren Lagen der Leiterplatte 2 und über Durchkontaktierungen in bekannter Weise miteinander verbunden sind. Die elektrischen Anschlüsse der auf dem Multichipmodul vorgesehenen Schaltung sind über Durchkontaktierungen 6 auf die Unterseite 4 der Leiterplatte 2 geführt und dort mit Lötkontakten 5 in Form von Solder bumps verbunden. Das Multichipmodul 1 wird mit den Solder bumps 5 auf entsprechend ausgerichtete Kontaktflecken eines nicht gezeigten Baugruppenträgers aufgesetzt und mit diesen im Reflowlötverfahren verlötet.

Auf der Oberseite 3 der Mehrlagenleiterplatte 2 sind außer den Bauelementen 7 mehrere IC-Bauelemente 30 (integrierte Schaltkreise) vorgesehen, von denen in Fig. 1 der Einfachheit halber nur eines dargestellt ist. Das IC-Bauelement 30 ist auf ein plattenförmiges Trägerteil 20 in Chip-on-Board-Technik aufgebracht. Das Trägerteil 20 ist wiederum auf die Oberseite 3 der Leiterplatte 2 aufgesetzt. Das plattenförmige Trägerteil 20 ist in dem gezeigten Ausführungsbeispiel als keramisches Mehrlagensubstrat (Multilayer-Keramik) ausgebildet und besteht aus mehreren isolierenden Keramikschichten, zwischen denen Leiterbahnen vorgesehen sind, die über Durchkontaktierungen (Vias) miteinander verbunden sind. Die Strukturgrößen der Leiterbahnen und Durchkontaktierungen auf dem keramischen Mehrlagensubstrat sind typischer Weise kleiner als die entsprechenden Strukturgrößen auf der Leiterplatte 2. Es ist aber auch die Verwendung anderer Trägersubstrate für das Trägerteil denkbar, wie z.B. die Verwendung eines Siliciumsubstrats oder einer einfachen Keramikplatte.

Das in Fig. 1 gezeigte IC-Bauelemente 30 ist über eine Klebstoffschicht 31 mit der Multilayer-Keramik 20 verbunden, die wiederum über eine Kleberschicht 11, welche aus einem Wärmeleitkleber besteht, mit der Leiterplatte 2 verbunden ist. Die Grundfläche der Multilayer-Keramik 20 ist einerseits größer als die Grundfläche des IC-Bauelementes ausgelegt, andererseits aber so klein, daß die Multilayer-Keramik 20 zwischen den Anschlüssen 10 der Leiterbahnen 9 in dem zur Aufbringung eines IC-Bauelementes vorgesehenen Bereich auf die Leiterplatte 2 aufgeklebt werden kann. Auf dem nicht durch das IC-Bauelement 30 abgedeckten Teil der Oberfläche 25 der Multilayer-Keramik 20 sind Anschlußflächen 21 und Anschlußflächen 22 in Form von Bondpads vorgesehen. Die Anschlußflächen 21 sind über Bonddrähte 23 mit den Anschlüssen des IC-Bauelementes 30 verbunden. Die Anschlußflächen 22 sind wiederum über weitere Bonddrähte 12 mit den Anschlüssen 10 der Leiterbahnen 9 verbunden. Weiterhin sind auf der Oberfläche 25 zwischen den ersten Anschlußflächen 21 und den zweiten Anschlußflächen 22 in Dünnschichttechnik hergestellte diskrete Widerstände 24 zur Unterdrückung von elektrischen Störsignalen aufgebracht. Die Widerstände 24 können direkt oder über weitere auf der Oberseite 25 vorgesehene Leiterbahnen mit den Anschlußflächen 21 und 22 verbunden sein. Leiterbahnen und Widerstände können alternativ auch in Dickschichttechnik hergestellt werden. Weiterhin ist es möglich, Leiterbahnen und Widerstände auf der Oberseite 25 auch unterhalb des IC-Bauelementes vorzusehen. Dies ist insbesondere vorteilhaft, wenn als Trägerteil 20 nur eine einlagige Keramikplatte verwandt wird. Das IC-Bauelement wird dann getrennt durch einen elektrisch isolierenden Kleber auf die Oberseite 25 mit den Leiterbahnen und Widerständen aufgesetzt. Ist das Trägerteil 20 eine Multilayer-Keramik, wie in dem in Fig. 1 gezeigten Beispiel, dann sind auch Leiterbahnen auf den inneren Lagen der Multilayer-Keramik 20 vorgesehen, welche über Durchkontaktierungen (Vias) mit den Leiterbahnen und Anschlußflächen 21,22 auf der Oberseite 25 verbunden sind. Auf der Oberseite 25 und den inneren Lagen der Multilayer-Keramik 20 ist somit ein Großteil der elektrischen Leitungsverbindungen zwischen dem IC-Bauelement 30 und den Widerständen 24 vorgesehenen. Auf der Leiterplatte 2 kann deshalb die Leiterbahndichte und die Lagenzahl verringert werden.

Außer den Leiterbahnen und den diskreten Widerständen 24 sind in dem hier gezeigten Ausführungsbeispiel noch weitere kapazitive Bauelemente 28 und induktive Bauelemente 27 als integrierte Bauelemente auf der Oberseite 25 oder einer der inneren Lagen der der Multilayer-Keramik 20 vorgesehen. Dabei können kapazitive Bauelemente 28, wie z.B. Kondensatoren über flächig auf den einzelnen Lagen aufgebrachte, als Elektroden dienende Leiterbahnen, die durch dielektrische Zwischenschichten getrennt sind, in an sich bekannter Weise erzeugt werden. Induktive Bauelemente, wie z.B. Spulen, können durch einzelne Leiterbahnen mit geeigneter Länge und Form erzeugt werden.

Durch die feinstrukturierten Leiterbahnen, die Widerstände 24 und die kapazitiven und induktiven Bauelemente 27 und 28 auf der Oberseite 25 und den inneren Lagen der Multilayer-Keramik 20 sowie durch die Aufbringung der Anschlußflächen 21,22 auf dem nicht durch das Bauelement 30 abgedeckten Teil der Oberseite 25 kann das Multichipmodul kleiner und kostengünstiger als bisher gefertigt werden.

## Patentansprüche

1. Multichipmodul (1) mit einem Trägersubstrat (2), auf dessen Bestückungsseite (3) wenigstens ein IC-Bauelement (30) und weitere elektronische Bauteile (7) aufgebracht sind, die über elektrisch leitende Verbindungen (9,12,23) miteinander verbunden sind, wobei elektrische Durchleitungen (6) von der Bestückungsseite (3) auf die Unterseite (4) des Trägersubstrats geführt sind und mit auf der Unterseite (4) zur elektrischen Verbindung des Multichipmoduls (1) mit einem Baugruppenträger angeordneten Lötkontakten (5) verbunden sind, und mit einem zwischen jeweils einem IC-Bauelement (30) und dem Trägersubstrat (2) angeordneten Trägerteil (20), welches Leiterbahnen und/oder Bauelemente (24,27,28) aufweist, wobei die Grundfläche des Trägerteils (20) größer als die Grundfläche des wenigstens einen IC-Bauelementes (30) ausgebildet ist und auf der nicht durch das IC-Bauelement (30) abgedeckten Oberseite (25) des Trägerteils (20) erste und zweite Anschlußflächen (21,22) vorgesehen sind und die ersten Anschlußflächen (21) über Bonddrähte (23) mit dem IC-Bauelement (30) elektrisch verbunden sind und die zweiten Anschlußflächen (22) über weitere Bonddrähte (12) mit Anschlüssen (10) auf der Bestückungsseite (3) des Trägersubstrats (2) verbunden sind, **dadurch gekennzeichnet, daß** auf der Oberseite (25) des Trägerteils (20) als elektrische Bauelemente (24) diskrete Widerstände zur Unterdrückung elektrischer Störsignale vorgesehen sind, die mit den ersten und zweiten Anschlußflächen (21,22) elektrisch verbunden sind.

2. Multichipmodul nach Anspruch 1, **dadurch gekennzeichnet, daß** das Trägerteil (20) ein Siliciumsubstrat ist.

3. Multichipmodul nach Anspruch 2, **dadurch gekennzeichnet, daß** das Trägerteil (20) ein Keramiksubstrat ist.

4. Multichipmodul nach Anspruch 3, **dadurch gekennzeichnet, daß** das Trägerteil (20) ein keramisches Mehrlagensubstrat ist, bei dem Leiterbahnen und Bauelemente (24,27,28) in mehreren durch isolierende Keramikschichten voneinander getrennten Lagen vorgesehen sind, die über Durchkontaktierungen (Vias) elektrisch leitend verbunden sind.

5. Multichipmodul nach Anspruch 3 oder 4, **dadurch gekennzeichnet, daß** die Widerstände (24) und Leiterbahnen in Dünn- oder Dickschichttechnik aufgebracht sind.

6. Multichipmodul nach Anspruch 4, **dadurch gekennzeichnet, daß** auf der Oberseite (25) oder einer der inneren Lagen des keramischen Mehrlagensubstrats (20) induktive Bauelemente (27) und/oder kapazitive Bauelemente (28) vorgesehen sind.

7. Multichipmodul nach einem der vorstehenden Ansprüche, **dadurch gekennzeichnet, daß** das Trägerteil (20) auf das Trägersubstrat (2) aufgeklebt ist.

8. Multichipmodul nach Anspruch 7, **dadurch gekennzeichnet, daß** das Trägerteil (20) mittels eines Wärmeleitklebers (11) auf das Trägersubstrat (2) aufgeklebt ist.

## Claims

1. Multichip module (1) with a carrier substrate (2), on the component side (3) of which at least one IC device (30) and further electronic components (7) are applied, which are connected to one another by means of electrically conducting connections (9, 12, 23), electrical interfacial lines (6) being led from the component side (3) to the underside (4) of the carrier substrate and connected to solder contacts (5) arranged on the underside (4) for the electrical connection of the multichip module (1) to a mounting rack, and with a carrier part (20), which is arranged between a respective IC device (30) and the carrier substrate (2) and has interconnects and/or components (24, 27, 28), the base area of the carrier part (20) being made larger than the base area of the at least one IC device (30) and first and second terminal areas (21, 22) being provided on the upper side (25) of the carrier part (20) not covered by the IC device (30), and the first terminal areas (21) being electrically connected to the IC device (30) by means of bonding wires (23) and the second terminal areas (22) being connected to terminals (10) on the component side (3) of the carrier substrate (2) by means of further bonding wires (12), **characterized in that** discrete resistors for suppressing electrical interference signals, which are electrically connected to the first and second terminal areas (21, 22), are provided on the upper side (25) of the carrier part (20) as electrical components (24).

2. Multichip module according to Claim 1, **characterized in that** the carrier part (20) is a silicon substrate.

3. Multichip module according to Claim 2, **characterized in that** the carrier part (20) is a ceramic substrate.

4. Multichip module according to Claim 3, **characterized in that** the carrier part (20) is a ceramic multilayer substrate, in which interconnects and components (24, 27, 28) are provided in a plurality of layers which are separated from one another by insulating ceramic layers and are connected in an electrically conducting manner by means of plated-through holes (vias).

5. Multichip module according to Claim 3 or 4, **characterized in that** the resistors (24) and interconnects are applied by a thin-film or thick-film technique.

6. Multichip module according to Claim 4, **characterized in that** inductive components (27) and/or capacitive components (28) are provided on the upper side (25) or one of the inner layers of the ceramic multilayer substrate (20).

7. Multichip module according to one of the preceding claims, **characterized in that** the carrier part (20) is adhesively attached to the carrier substrate (2).

8. Multichip module according to Claim 7, **characterized in that** the carrier part (20) is adhesively attached to the carrier substrate (2) by means of a heat-conducting adhesive (11).

## Revendications

1. Module multipuce (1) comportant un substrat de support (2) dont le côté de garniture (3) reçoit au moins un composant à circuit intégré (30) ainsi que d'autres composants électroniques (7) reliés par des liaisons conductrices électriques (9, 12, 23) les uns aux autres,
des lignes électriques (6) traversant de la face de garniture (3) jusqu'à la face inférieure (4) du substrat de support en étant reliées à des contacts brasés (5) montés sur le côté inférieur (4) pour assurer la liaison électrique du module multipuce (1) avec un support de groupes de composants, et une pièce de support (20) prévue entre chaque composant à circuit intégré (30) et le substrat de support (2), cette pièce ayant des chemins conducteurs et/ou des composants (24, 27, 28), la surface de base de la pièce de support (20) étant plus grande que la surface de base d'au moins un composant à circuit intégré (30), tandis que la face supérieure (25) de la pièce de support (20) non couverte par le composant à circuit intégré (30), a des premières et des secondes surfaces de branchement (21, 22), dont
les premières surfaces de branchement (21) sont reliées par des fils de liaison (23) au composant à circuit intégré (30) par une liaison électrique et les seconds fils de branchement (22) sont reliés par d'autres fils de liaison (12) au branchement (10) du côté de garniture (3) du substrat de support (2),
**caractérisé en ce que**
la face supérieure (25) de la pièce de support (20) comporte comme composants électriques (24), des résistances discrètes pour supprimer les signaux électriques perturbateurs, reliées électriquement aux premières et secondes surfaces de branchement (21, 22).

2. Module multipuce selon la revendication 1,
**caractérisé en ce que**
la pièce de support (2) est un substrat de silicium.

3. Module multipuce selon la revendication 2,
**caractérisé en ce que**
la pièce de support (2) est un substrat en céramique.

4. Module multipuce selon la revendication 3,
**caractérisé en ce que**
la pièce de support (20) est un substrat multicouche céramique dont les chemins conducteurs et les composants (24, 27, 28) sont prévus dans plusieurs couches séparées par des couches de céramique isolantes reliées électriquement par des contacts traversants (voies).

5. Module multipuce selon l'une quelconque des revendications 3 ou 4,
**caractérisé en ce que**
les résistances (24) et les chemins conducteurs sont appliqués en technique des couches minces ou des couches épaisses.

6. Module multipuce selon la revendication 4,
**caractérisé en ce que**
des composants inductifs (27) et/ou des composants capacitifs (28) sont prévus sur la face supérieure (25) ou l'une des couches intérieures du substrat multicouche (20) en céramique.

7. Module multipuce selon l'une quelconque des revendications précédentes,
**caractérisé en ce que**
la pièce de support (20) est collée sur le substrat de support (2).

8. Module multipuce selon la revendication 7,
**caractérisé en ce que**
la pièce de support (20) est collée par une colle thermoconductrice (11) sur le substrat de support (2).
